# EUROPÄISCHE PATENTSCHRIFT

(11) **EP 1 778 892 B1**
(45) Veröffentlichungstag und Bekanntmachung des Hinweises auf die Patenterteilung: **10.11.2010**
(21) Anmeldenummer: 05796899.2
(22) Anmeldetag: 05.08.2005
(51) Int. Cl.: C23C 18/12, C04B 35/50, C04B 35/624, H01B 3/12, H01L 39/14, H01B 12/02

(54) **VERFAHREN ZUR HERSTELLUNG HOCHTEXTURIERTER, BANDFÖRMIGER HOCHTEMPERATUR-SUPRALEITER**
METHOD FOR PRODUCING HIGHLY TEXTURED, STRIP-SHAPED HIGH-TEMPERATURE SUPERCONDUCTORS
PROCEDE DE FABRICATION DE SUPRACONDUCTEURS A HAUTE TEMPERATURE CRITIQUE FORTEMENT TEXTURES ET EN FORME DE BANDES

(30) Priorität: 05.08.2004 DE 102004038030
(43) Veröffentlichungstag der Anmeldung: 02.05.2007
(73) Patentinhaber: Zenergy Power GmbH, 53359 Rheinbach (DE)
(72) Erfinder: BÄCKER, Michael, 50670 Köln (DE); SCHLOBACH, Brigitte, 01728 Bannewitz (DE); KNOTH, Kerstin, 01309 Dresden (DE); SCHÜPP-NIEWA, Barbara, 85399 Hallbergmoos (DE); HÜHNE, Ruben, 01099 Dresden (DE); FALTER, Martina, 53913 Swisttal- Buschhoven (DE)
(74) Vertreter: Prietsch, Reiner
(86) Internationale Anmeldenummer: PCT/EP2005/008534
(87) Internationale Veröffentlichungsnummer: WO 2006/015819

(56) Entgegenhaltungen:
- CELIK E ET AL: "Nb-doped SrTiO3 buffer layers on LaAlO3 substrates by metalorganic deposition for YBCO superconducting films" MATERIALS SCIENCE AND ENGINEERING B, ELSEVIER SEQUOIA, LAUSANNE, CH, Bd. 110, Nr. 1, 25. Juni 2004 (2004-06-25), Seiten 94-102, XP004507156 ISSN: 0921-5107
- CASTANO O ET AL: "Epitaxial nucleation and growth of buffer layers and Y123 coated conductors deposited by metal-organic decomposition" PHYSICA C, NORTH-HOLLAND PUBLISHING, AMSTERDAM, NL, Bd. 372-376, August 2002 (2002-08), Seiten 806-809, XP004375539 ISSN: 0921-4534
- CHIRAYIL T G ET AL: "Epitaxial growth of La2Zr2O7 thin films on rolled Ni-substrates by sol-gel process for high Tc superconducting tapes" PHYSICA C, NORTH-HOLLAND PUBLISHING, AMSTERDAM, NL, Bd. 336, Nr. 1-2, Juli 2000 (2000-07), Seiten 63-69, XP004208161 ISSN: 0921-4534
- CELIK E ET AL: "Fabrication of La2Zr2O7 buffer layers on Ni tapes by reel-to-reel sol-gel technique" MATERIALS SCIENCE AND ENGINEERING B, ELSEVIER SEQUOIA, LAUSANNE, CH, Bd. 106, Nr. 2, 25. Januar 2004 (2004-01-25), Seiten 182-190, XP004482186 ISSN: 0921-5107
- BHUIYAN M S ET AL: "MOD approach for the growth of epitaxial CeO2 buffer layers on biaxially textured Ni-W substrates for YBCO coated conductors" SUPERCOND. SCI. TECHNOL., Bd. 16, 17. Oktober 2003 (2003-10-17), Seiten 1305-1309, XP002362939 UK
- ANNAVARAPU S ET AL: "Progress towards a low-cost coated conductor technology" PHYSICA C, NORTH-HOLLAND PUBLISHING, AMSTERDAM, NL, Bd. 341-348, November 2000 (2000-11), Seiten 2319-2322, XP004761706 ISSN: 0921-4534

## Beschreibung

### Technisches Gebiet

Die Erfindung betrifft ein Verfahren zur Herstellung hochtexturierter, bandförmiger Hochtemperatur-Supraleiter sowie die Zwischen- und Endprodukte des Verfahrens.

Nachfolgend wird auf die Dokumente D1-D10 bezug genommen:
D1: S. Sathyamurthy, M. Paranthaman, H-Y. Zhai, H.M. Christen, P.M. Martin, and A. Goyal, J. Mater. Res., Vol. 17, No. 9, 2002, 2181-2184
D2: T.G. Chirayil, M. Paranthaman, D.B. Beach, D.F. Lee, A. Goyal, R.K. Williams, X. Cui, D.M. Kroeger, R. Feenstra, D.T. Verebelyi, D.K. Christen, Physica C 336, 2000, 63-69
D3: S. Sathyamurthy, M. Paranthaman, T. Aytug, B.W. Kang, P.M. Martin, A. Goyal, D.M. Kroeger, D.K. Christen, J. Mater. Res., Vol. 17, No. 6, 2002, 1543-1549
D4: E. Celik, Y. Akin, W. Sigmund, Y.S. Hascicek, Mat. Sci. Eng. B 106, 2004, 182-190.
D5: M.S. Bhuiyan, M. Paranthaman, S. Sathyamurthy, T. Aytug, S. Kang, D.F. Lee, A. Goyal, E.A. Payzant, and K Salama, Supercond. Sci. Technol. 16, 2003, 1305-1309
D6: Mutlu, I.H.; Aslanoglu, Z.; El-Kawni, M.I.; Celik, E.; Okuyucu, H.; Akin, Y.; Sigmund, W. and Hascicek, Y.S., Adv. Cryog. Eng. 48B, 2002, 589-594
D7: High Temperature Superconductivity 1: Materials, A.V. Narlikar (Ed.), Springer-Verlag, 2004, 115-167
D8: DE 101 43 680 Verfahren zur Herstellung von Metallbändern mit hochgradiger Würfeltextur; J. Eickemeyer, D. Selbmann, R. Opitz
D9: CN 1 117 879 Metallischer Werkstoff auf Nickelbasis und Verfahren zu dessen Herstellung; J. Eickemeyer, D. Selbmann, R. Opitz, B. Holzapfel
D10: DE 1000 05 861 Metallischer Werkstoff auf Nickelbasis und Verfahren zu dessen Herstellung; J. Eickemeyer, D. Selbmann, R. Opitz, B. Holzapfel

### Stand der Technik

Einige Kupratsupraleiter sind bereits oberhalb der Siedetemperatur von flüssigem Stickstoff (77K) supraleitend. Die Kupratsupraleiter werden deshalb auch Hochtemperatur-supraleiter (HTSL) genannt. Allerdings haben diese Supraleiter schlechte mechanische Eigenschaften. Ein Ansatz, um die damit verbundenen Probleme zu überwinden, ist die Entwicklung von Bandleitern.

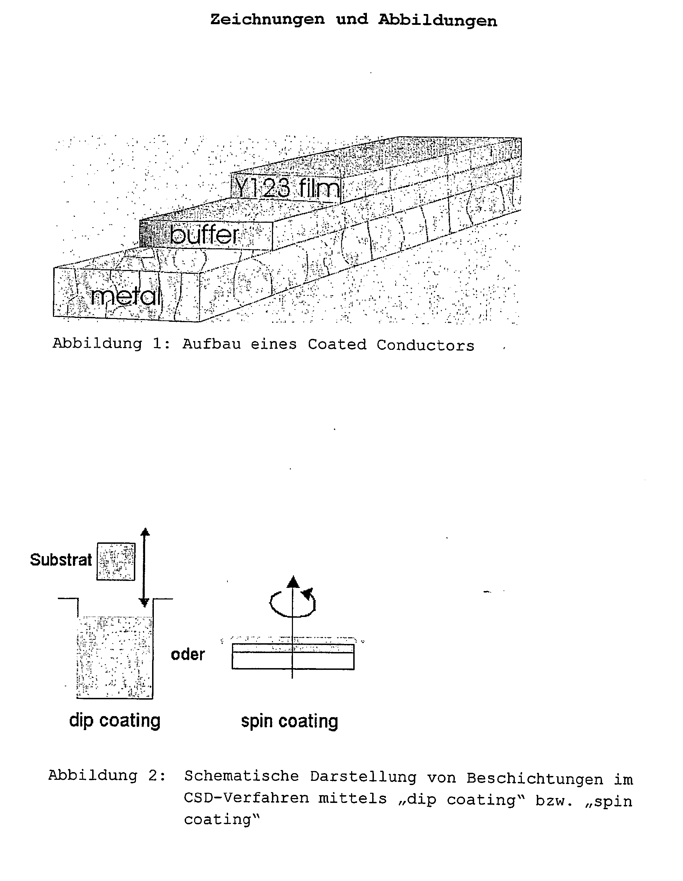

Bandleiter (Band-HTSL oder bandförmige HTSL) sind sogenannte Coated Conductors, die eine supraleitende Funktionsschicht haben, die über ein spezielles Verfahren auf ein bandförmiges Substrat aufgebracht wird. Als Funktionsschicht kann z.B. Yttrium-Barium-Kupfer-Oxid YBa₂Cu₃Oₓ (YBCO) zum Einsatz kommen. Diese Bandleiter weisen i.a. eine Struktur aus Metallsubstrat, Pufferschicht und supraleitender Schicht auf (vgl. Abbildung 1). Die Wirtschaftlichkeit des Herstellungsprozesses wird maßgeblich durch das Abscheideverfahren bestimmt.

Hauptschwierigkeit der Produktion von Coated Conductors ist die Tatsache, daß die supraleitende Schicht eine extrem hohe Textur, d.h. kristallographische Orientierung aufweisen muß. Die einzelnen Kristallite der Schicht dürfen nur um einen minimalen Betrag gegeneinander verkippt sein, da sonst die supraleitenden Eigenschaften massiv beeinträchtigt werden (D7).

Um einen solchen hohen Texturgrad zu erreichen, werden zwei unterschiedliche Herstellungsansätze verfolgt. Beiden Ansätzen ist gemein, daß vor dem Abscheiden der Supraleiterschicht eine texturierte Pufferschicht erzeugt wird, die ihre Textur, d.h. Orientierung, an den Supraleiter bei dessen Abscheidung überträgt. Bei beiden Ansätzen werden Metallsubstrate verwendet, weil nur so die für die spätere Verwendung in elektrotechnischen Anwendungen erforderliche Festigkeit der Bandleiter erreicht werden kann. Im ersten Ansatz wird von einem untexturierten, kristallographisch nicht orientierten, metallischen Substrat ausgegangen, wobei zumeist eine Hastelloy (Handelsmarke) Legierung verwendet wird. Auf dieses untexturierte Substrat wird anschließend die Pufferschicht mit einer Orientierung aufgebracht. Eine solche gerichtete Abscheidung kann nur mittels physikalischer Beschichtungsverfahren, z.B. Ion Beam Assisted Deposition (IBAD) und Inclined Substrate Deposition (ISD), im Hochvakuum erfolgen. Entscheidende Nachteile dieser Verfahren sind der hohe apparative Aufwand, z.B. durch das zu verwendende Hochvakuum und die nur geringen Abscheideraten. Im zweiten Ansatz wird bereits das Metallsubstrat durch spezielle Umform-und Temperaturbehandlungsprozeße texturiert (D8, D9, D10). Die Textur des Substrates kann damit auf die Pufferschicht und von dort auf die Supraleiterschicht übertragen werden. Vorteil dieser Methode ist, daß keine gerichteten Abscheideverfahren angewendet werden müssen. Hier können u.a. sowohl physikalische Verfahren, wie Pulsed Laser Deposition (PLD) und Thermische Co-Verdampfung (Thermal Co-Evaporation, TCE), als auch chemische Verfahren wie Chemical Solution Deposition (CSD) und Metal-Organic Chemical Vapour Deposition (MOCVD) eingesetzt werden. Für die genannten physikalischen Verfahren gilt prinzipiell das zum ersten Verfahrensansatz Gesagte, wobei die Abscheideraten der physikalischen Verfahren mit ungerichteter Abscheidung deutlich höher sind.

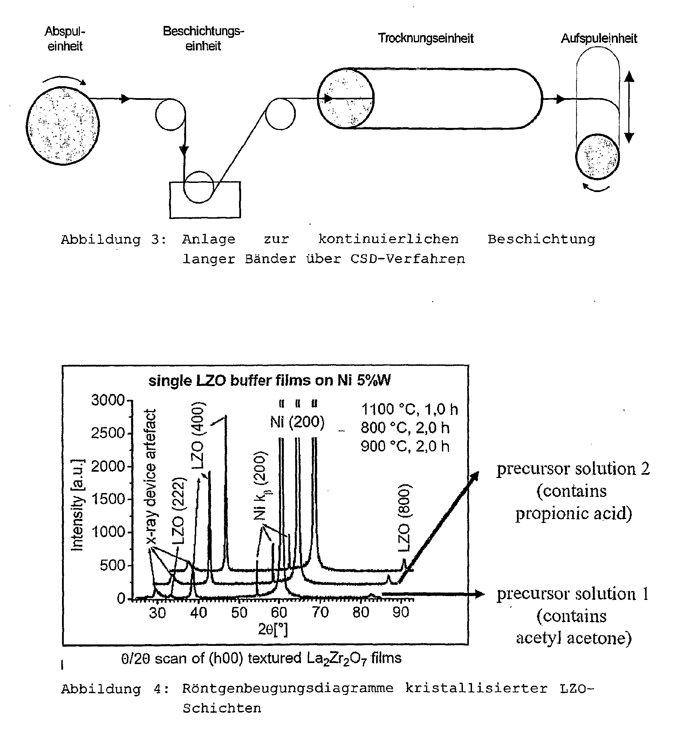

Besonders ökonomisch, bezüglich Anlagen- als auch Betriebskosten, sind chemische Beschichtungsverfahren, da diese i.a. bei Normaldruck, d.h. ohne Hochvakuum, arbeiten und eine sehr viel höhere Abscheiderate ermöglichen. Daher stehen weltweit CSD-Verfahren (Chemical Solution Deposition), die im Gegensatz zu physikalischen Beschichtungsmethoden bei Normaldruck erfolgen, im Mittelpunkt zahlreicher Entwicklungen (D7). Im Labormaßstab erfolgt die Beschichtung mit CSD-Verfahren als "dip coating", indem das Substrat in eine Lösung eingetaucht und wieder herausgezogen wird, oder als "spin coating". Hier werden einige Tropfen der Lösung auf ein Substrat aufgebracht und durch Rotation des Substrats verteilt (vgl. Abbildung 2). Zur Produktion von größeren Längen kann das Substratband durch eine Beschichtungslösung gezogen und anschließend in einem Ofen getrocknet werden (D6). Eine schematische Darstellung einer solchen Anlage ist Abbildung 3 zu entnehmen. Die anschließende Umsetzung erfolgt bei höherer Temperatur.

Eine Coated Conductor Architektur bzw. Schichtfolge unter Verzicht auf eine Pufferschicht ist aus physikalischer Sicht nicht möglich, da diese Schicht vor allem als Diffusionsbarriere benötigt wird. Einerseits soll diese Schicht verhindern, daß Metallatome aus dem Metallbandsubstrat (z.B. Nickel) bei der abschließenden Glühbehandlung in den Supraleiter diffundieren, diesen vergiften und so die supraleitenden Eigenschaften verschlechtern. Andererseits fungiert diese Pufferschicht als Sauerstoffbarriere, damit ebenfalls bei der abschließenden Glühbehandlung kein Sauerstoff durch die Pufferschicht zum Metallsubstratband diffundieren kann. Dort würde es zur Bildung einer Metalloxid-Grenzschicht kommen, die zum Abplatzen der Puffer- und Supraleiterschicht führen kann.

Wegen der oben genannten Vorteile wird als Herstellungsprozeß für Coated Conductors die Verwendung eines texturierten Metallsubstratbandes (D8) bevorzugt, auf dem über chemische Abscheidung eine Pufferschicht und die eigentliche supraleitende Schicht aufgebracht wird. Auf die einzelnen Abscheidungsschritte folgt dabei jeweils eine Glühbehandlung, bei der die abgeschiedenen Materialien so kristallisieren sollen, daß die Textur von der darunter liegenden Schicht bzw. des Substrats übernommen wird.

Bei diesem Prozeß handelt es sich um einen so genannten "all-solution" Prozeß, der bezüglich der Beschichtungen nur von Lösungen der Einzelkomponenten und einer Beschichtung bei Umgebungsdruck ausgeht.

Während für die supraleitende Schicht z.B. Yttrium-Barium-Kupfer-Oxid verwendet wird, können für die Pufferschicht verschiedenste Verbindungen genutzt werden. Grundvoraussetzung ist die Eigenschaft, texturiert abgeschieden zu werden und diese Textur an die supraleitende Schicht weiterzugeben. Neben Einfachschichten werden auch mehrlagige Pufferschichtsysteme verwendet. Typische verwendete Materialien sind yttriumstabilisiertes Zirkonoxid, Gadolinium-Zirkonat, Yttriumoxid, Lanthan-Aluminat, Lanthan-Zirkonat, Strontium-Titanat, Nickeloxid, Ceroxid, Magnesiumoxid, Lanthan-Manganat, Strontium-Ruthenat und viele andere mehr (D1, D2, D3, D4, D5, D7).

Bisher konnte mittels "all-solution" Prozeßen kein Bandleiter realisiertwerden, der ähnlich hohe elektrische Stromdichten aufweist, wie Bandleiter bei denen mindestens eine Schicht mittels physikalischer Methoden, z.B. mit Pulsed Laser Deposition (PLD), aufgebracht wurde. Aus Untersuchungen ist bekannt, daß die Realisierung von Coated Conductors über CSD Verfahren maßgeblich an der Erzeugung solcher Pufferschichten scheitert, die ihre Textur auf die Supraleiterschicht übertragen können. Dies wurde u.a. dadurch nachgewiesen, daß auch eine Abscheidung der Supraleiterschicht mit physikalischen Methoden, die auf physikalisch abgeschiedenen Pufferschichten nachweislich zu hochqualitativen Schichten führt, auf CSD Pufferschichten nur zu einer geringen Textur der Supraleiterschicht und damit zu schlechten supraleitenden Eigenschaften führt. Dies ist durch einen mangelnden Texturübertrag zu begründen.

Zusätzlich zum Nachteil des oben beschriebenen schlechten Texturübertragungsvermögens von CSD Pufferschichten gehen die bisher beschriebenen Verfahren zur Abscheidung von Pufferschichten über CSD Verfahren hauptsächlich von Lösungen aus, denen als Lösungsmittel 2-Methoxyethanol zugrunde liegt (D1, D2, D3). Dieses Lösungsmittel ist als giftig, frucht- und fertilitätsschädigend eingestuft, und daher für Laboranwendung sowie technische Anwendungen eher ungeeignet. Außerdem sind die Ausgangsstoffe für das Beispiel der Herstellung von La₂Zr₂O₇ (Lanthan-isopropoxid und Zirconium-n-propoxid) feuchtigkeitsempfindlich, so daß die Herstellung der Lösung unter InertAtmosphäre stattfinden muß.

Ein weiterer Nachteil bisheriger CSD-Verfahren zum Aufbringen der Pufferschichten sind die benötigten hohen Temperaturen zur Kristallisation der Pufferschichten, die oftmals deutlich oberhalb von 1000°C liegen (D4) und damit die Auswahl an geeigneten Metallsubstraten stark einschränken. Außerdem ist selbst bei Substraten, welche eine ausreichend hohe Schmelz- bzw. Erweichungstemperatur aufweisen, die Diffusionsgeschwindigkeit bei Temperaturen oberhalb von 1000°C so hoch, daß in den Pufferschichten hohe Verunreinigungen an eindiffundierten Metallatomen aus dem Substrat nachgewiesen werden können.

### Aufgabenstellung

Die Aufgabe der Erfindung besteht darin, das CSD-Verfahren zur Herstellung von bandförmigen HTSL dahingehend weiter zu entwickeln, daß das Texturübertragungsvermögen der Pufferschicht verbessert wird.

### Lösung der Aufgabenstellung

Das Ziel der Erfindung wird durch die Verwendung von polaren Lösungsmitteln mit freien Hydroxylgruppen, insbesondere Propionsäure als Lösungsmittel für die Puffersubstanzen und der Anpassung der Abscheidebedingungen an die neuen Beschichtungslösungen erreicht. Gemäß der Aufgabe konnte hierdurch ein hohes Texturübertragungsvermögen bei gleichzeitiger Vermeidung giftiger Lösungsmittel und einer Erniedrigung der Glühtemperatur erreicht werden.

Bezüglich des Verfahrens und des bandförmigen HTSL wird auf die Ansprüche verwiesen.

Für die Entwicklung neuer Verfahren und Beschichtungssysteme, welche zumindest die Aufgabe eines hohen Texturübertragungsvermögens erfüllen, muß zunächst die Ursache für den mangelnden Texturübertrag von Puffer zu Supraleiter bei konventioneller CSD Beschichtung geklärt werden. Die Betrachtung der Gesamttextur der Pufferschicht erfolgt zumeist über Röntgen-oder Elektronenbeugung (D4). Die Eindringtiefe dieser Messmethoden, d.h. die Materialtiefe aus der noch Messinformationen erhalten werden, ist größer als die Dicke der zu messenden Schicht. Mit entsprechenden Messungen wurden in allen bisher abgeschiedenen Pufferschichten sehr gute Texturwerte erhalten, mit typischen Halbwertsbreiten im Bereich von 6-7° (2θ), die aus Polfiguren berechnet werden können. Diese Gradzahl ist ein Maß für die Streuung der Kristallausrichtungen um den Idealwert. Die bei über CSD-Verfahren abgeschiedenen Pufferschichten gemessenen Werte entsprechen denen, die bei physikalisch abgeschiedenen Pufferschichten gemessen wurden. Aufgrund der gemessenen Werte sollte es daher prinzipiell möglich sein, vergleichbar gut texturierte YBCO-Schichten auf dem CSD-Puffer abzuscheiden. Diese Abscheidung gelingt jedoch nur mit einem vergleichsweise sehr schlechten Texturierungsgrad und damit schlechten supraleitenden Eigenschaften. Diese Standardbeugungsmessungen waren daher zur Erfassung des Texturübertragungsvermögens der Pufferschicht ungeeignet.

Da der Texturübertrag durch die oberste Deckschicht der Pufferschicht erfolgen muß, wurde diese Schicht mittels RHEED (Reflection high-energy electron diffraction) untersucht. Die Ergebnisse dieser Messungen an herkömmlichen über CSD erzeugten Pufferschichten zeigten, daß sich auf der im Inneren sehr gut texturierten CSD-Pufferschicht eine wenige Nanometer dicke amorphe Deckschicht befindet, die bei allen gebräuchlichen Puffersystemen (beispielsweise La₂Zr₂O₇ (LZO), CeO₂/Gd₂O₃, Y-stabilisiertes ZrO₂ (YSZ)), welche mittels CSD abgeschieden wurden, beobachtet werden konnte. Diese amorphe Deckschicht verhindert, daß qualitativ hochwertige Supraleiterschichten auf Pufferschichten abgeschieden werden können, welche mit herkömmlichen Beschichtungslösungen und -verfahren über CSD hergestellt wurden. Eine Pufferschicht mit einem hohen Texturübertragungsvermögen, muß daher in RHEED-Messungen einen hohen Texturgrad auch der äußersten Pufferschicht, d.h. bis zur Pufferschichtoberfläche, zeigen.

Erfindungsgemäße Beschichtungslösungen und Prozeßparameter bewirken, daß sich die bisher beobachtete, amorphe Deckschicht nicht ausbildet und die Pufferschicht vollständig bis an die Oberfläche kristallisiert. Dieser Befund wurde mittels RHEED Aufnahmen von erfindungsgemäß hergestellten Pufferschichten eindeutig verifiziert. Erfindungsgemäße Pufferschichten ermöglichen damit erstmals die Herstellung von hochwertigen Coated Conductors über den "all-solution" Prozeß, bzw. generell die Abscheidung von qualitativ hochwertigen Supraleiterschichten auf CSD Pufferschichten.

Bei Verwendung von polaren Lösungsmitteln mit freien Hydroxylgruppen konnte eine deutlich bessere Kristallinität der Oberfläche der Pufferschichten erreicht werden. Vorteilhaft sind demnach z.B. Carbonsäuren als Lösungsmittel, die außerdem den Vorteil besitzen, daß sie die Metallsubstratoberfläche leicht anätzen könnten und dadurch in-situ reinigen und so auch von dieser Seite eine optimale Texturentwicklung ermöglichen. Die Carbonsäuren besitzen außerdem den Vorteil, daß sie i.a. nicht als gesundheitsschädlich eingestuft sind. Die kommerzielle Umsetzung des Verfahrens mit diesen Lösungsmitteln gestaltet sich dabei sowohl im Hinblick auf die Sicherheit der Beschäftigten, als auch im Hinblick auf die Ökonomie des Prozesses, durch weniger notwendige apparative Sicherungsmaßnahmen deutlich günstiger im Vergleich zur Verwendung herkömmlicher Lösungsmittel.

Vorteilhafte Puffersysteme, die unter Einsatz des erfindungsgemäßen Verfahrens hergestellt werden können, bestehen beispielsweise aus Zirkonaten und/oder Seltenerdoxiden. Konkrete Beispiele für solche Puffersysteme sind Yttriumoxid, Ceroxid oder gadoliniumdotiertes Ceroxid. Diese verschiedenen Puffersysteme können auch zu einem mehrlagigen Puffersystem kombiniert werden.

Zur Herstellung der Beschichtungslösungen kann es dabei vorteilhaft sein, diese zu erwärmen oder unter Rühren so zu erhitzen, daß diese im Rückfluss sieden. Des Weiteren können der Beschichtungslösung verschiedene Additive beigemischt werden, um den Beschichtungsprozeß positiv zu beeinflussen und die Lösungsstabilität zu erhöhen. Zur Prozeßverbesserung werden beispielsweise Benetzungsmittel eingesetzt, d.h. Mittel welche die Oberflächenspannung der Beschichtungslösung herabsetzen und so eine gleichmäßige Beschichtung über die Fläche und an Kanten ermöglichen und gleichzeitig der Bildung von Tropfen während der Trocknung entgegenwirken

Auch Geliermittel, die ein gleichmäßiges Trocknen der Beschichtung ohne Abplatzungen, Risse und Poren ermöglichen, werden verwendet. Zur Stabilisierung der Lösungen können u.a. Antioxidantien eingesetzt werden.

Die Beschichtung des Substrates mit der erfindungsgemäßen Beschichtungslösung kann auf verschiedene Arten erfolgen. Die Lösung kann durch dip-coating (Tauchen des Substrates in die Lösung), spin-coating (Aufbringen der Lösung auf ein rotierendes Substrat), spray-coating (Aufsprühen bzw. Zerstäuben der Lösung auf das Substrat), capillary-coating (Abringen der Lösung über eine Kapillare), ink-jet-printing (Tintenstahldrucken) und ähnliche Techniken aufgebracht werden. Bei der Aufbringung der Lösung können optional, entweder durch gezieltes Schützen von Bereichen, z.B. mittels Photolack und Entfernung nach der Beschichtung, oder durch das Verfahren selbst, z.B. bei Druckverfahren wie dem Ink-Jet-Printing, Strukturen in der Pufferschicht erzeugt werden.

Die Beschichtung und Trocknung kann generell - sowohl im Batchverfahren als auch kontinuierlich erfolgen. Bevorzugt sind hier aufgrund des geringeren Handhabungsaufwandes kontinuierliche Anlagen (vergl. Abbildung 3). Diese Anlagen bestehen aus einer Abspuleinheit mit aktiver oder passiver Bremse, um das Substratband in der Anlage unter Spannung zu halten. Dies kann z.B. durch einen so genannten Tänzer (doppelte Umlenkrollen mit definierter Zugkraft) erreicht werden. Das Substratband wird anschließend durch die Beschichtungseinheit geführt, welche z.B. aus einem Tauchbad bestehen kann. Durch variable Anordnungen der Führrollen können verschiedene Auszugswinkel des Substratbandes aus der Beschichtungslösung im Bad erreicht werden. Das Bad kann zusätzlich z.B. zur Erhöhung der Löslichkeit einzelner Komponenten im Lösungsmittel beheizt werden. Die Beschichtungseinheit kann erfindungsgemäß auch nach einem der weiteren oben genannten Verfahren (außer spin-coating) betrieben werden. Nach der Beschichtung erfolgt das Auftrocknen der Beschichtung in einer Trockenstrecke (Trocknungseinheit). Diese Strecke kann sowohl bei einer Temperatur, als auch mit mehreren Temperaturen und Temperaturverläufen, betrieben werden. Vorteilhaft ist eine mindestens zweistufige Trocknung mit einer niedrigen Temperatur *T*1, die wenig unterhalb der Siedetemperatur des verwendeten Lösungsmittels liegt, und einer Temperatur T2, die oberhalb der Siedetemperatur liegt. Durch dieses Verfahren wird ein besonders homogenes und damit riss-und porenfreies Auftrocknen erreicht. Nach dem Auftrocknen wird das Band über eine Aufspuleinheit wieder aufgewickelt. Vorteilhaft für die anschließende Glühbehandlung ist es das Band auf ein Trägerrohr in Form einer Flachspule (Solenoid) aufzuwickeln. Dies geschieht durch eine gleichzeitige Dreh- und Linearbewegung des Aufspulers. Träger für das Band ist z.B. ein wärmefestes Keramikrohr oder ein beschichtetes Metallrohr. Die verschiedenen Einheiten, insbesondere die Beschichtungseinheit und die Trocknungseinheit sind vorteilhaft so gestaltet,- daß der Prozeß unter einer definierten Atmosphäre stattfinden kann. In den verschiedenen Einheiten kann es vorteilhaft sein, unterschiedliche Atmosphären einzustellen. Z.B. kann ein hoher Dampfdruck des Lösungsmittels in der Beschichtungseinheit vorteilhaft sein, um ein übermäßiges Verdampfen des Lösungsmittels aus dem Beschichtungsbad und damit ein Aufkonzentrieren der Beschichtungslösung zu vermeiden.

Neben der durch die erfindungsgemäße Beschichtung erreichten Texturierung sind auch die Prozeßparameter der anschließenden Glühbehandlung von entscheidender Bedeutung für die technische Anwendbarkeit und die Ökonomie des Beschichtungsverfahrens. Bei erfindungsgemäß abgeschiedenen Pufferschichten setzt die Kristallisation bereits bei deutlich niedrigeren Temperaturen ein, als dies bei herkömmlichen Beschichtungslösungen bzw. Lösungsmitteln erfolgt. Die gereinigte Oberfläche scheint es zusätzlich zu ermöglichten, daß die Textur des Metallsubstratbandes schneller und fehlerfreier auf die Pufferschicht übertragen wird. Als typische Prozeßtemperaturen für die Glühbehandlung wurden Temperaturen von 800 - 900°C identifiziert.

Die niedrigen Glühtemperaturen bei der erfindungsgemäßen Beschichtung erlauben erstmals eine kontinuierliche Beschichtungsapparatur so zu gestalten, daß auch die abschließende Glühbehandlung kontinuierlich in einer Linie mit der Beschichtung und Trocknung erfolgen kann. Bisher wurde dies durch die benötigten hohen Temperaturen und die dadurch bedingte Erweichung des Substratbandes, die einen Transport des Bandes durch die Apparatur unter Zug ausschließt, verhindert.

Folgende Beispiele seien angeführt, ohne sich auf diese zu beschränken:

### Beispiel 1

Auf ein texturiertes Metallband wurde in -reproduzierbaren Versuchen La₂Zr₂O₇ (LZO) als Pufferschicht aufgebracht. Bei dem Metallband handelt es sich um ein Reinnickelband. Durch Einlegieren von Wolfram bis zu einem Anteil von 8% kann die Zugfestigkeit des Bandes ohne Einfluss auf das Ergebnis der Beschichtung in diesem Beispiel erhöht werden. Auch andere Legierungen wie z.B. Ni-0,1%Mn können ohne Einfluss auf das Endergebnis dieses Beispiels verwendet werden. In Vergleichsversuchen wurden unterschiedliche Beschichtungslösungen verwendet, wobei die erste Lösung dem Stand der Technik entspricht, während die zweite Lösung erfindungsgemäß ist.

Basis beider Beschichtungslösungen sind Lanthan(III)- und Zirkonium(IV)-(2,4)pentandionat (Acetylacetonat) (Lanthan(III)-(2,4)pentan-dionat, La[CH₃COCHCOCH₃]₃ ·x H₂O: Alfa Aesar, 99,9% (REO), Pulver, Schmelzpunkt: 143°C; Zirkonium(IV)-(2,4)penandionat, Zr[CH₃COCHCOCH₃]₄: Strem Chemicals, ≥98%, kristallin). Beide Lösungen wurden gemäß der Pufferstöchiometrie auf eine Konzentration von 0,1 M bezogen auf La₂Zr₂O₇ eingestellt. Höhere bzw. niedrigere Konzentrationen können in Grenzen (0,05 - 0,4 M) durch eine Variation der Auszugsgeschwindigkeit (s.u.) ohne Einfluß auf das Ergebnis kompensiert werden. Zur genauen Einstellung der Metallgehalte wurden die Ausgangsstoffe mittels ICP-OES (Inductively coupled plasma optical emission) charakterisiert. Als Lösungsmittel für Lösung 1 wurde Acetylaceton (2,4-Pentandion, CH₃COCH₂COCH₃: Merck, zur Analyse, ≥99,5%, Schmelzpunkt: -23°C, Siedepunkt: 140°C, Flammpunkt: 34°C) unter Zugabe von Isobutylamin (1-Amino-2-methylpropan, (CH₃)₂CHCH₂NH₂: Merck, zur Synthese, >98%, Schmelzpunkt: -85°C, Siedepunkt: 68°C, Flammpunkt: -10°C), für Lösung 2 Propionsäure (Propionsäure, CH₃CH₂COOH: Merck, ≥99%, Schmelzpunkt: -21°C, Siedepunkt: 141°C, Flammpunkt: 50°C) verwendet.

Die Beschichtung erfolgte an Substratstücken mit den Abmessungen 10 x 10 x 0,08 mm³ mittels einer Tauchapparatur. Die Proben wurden mit einer Geschwindigkeit von 0,2 cm/s mit einem Winkel von 90° zur Lösungsoberfläche aus der Beschichtungslösung gezogen. Die Geschwindigkeit kann auf bis zu 0,05cm/s verringert werden, niedrigere Geschwindigkeiten bewirken eine zu geringe Schichtdicke. Die Geschwindigkeit kann auf bis zu 0,5cm/s erhöht werden, oberhalb dieser Geschwindigkeit ergeben sich zu große Schichtdicken, welche im nachfolgenden Temperaturbehandlungsprozeß zur Rißbildung neigen.

Nach der Trocknung bei 60°C innerhalb von 5h unter Luft wurden die Proben verschiedenen Glühbehandlungen unterzogen. Die Trocknung erfolgt unterhalb des Siedepunktes des Lösungsmittels (Methanol; 64,5°C) um Blasenbildung durch Sieden zu verhindern. Die Röntgenbeugungsdiagramme (Abbildung 4) zeigen bei allen Proben eine gute Textur, wobei die Textur der Proben, die mit Lösung 2 hergestellt wurden, aufgrund des Fehlens des LZO (222) Reflexes sowie deutlich höherer Intensitäten der (h00) Reflexe im Röntgenbeugungsdiffraktogramm als besser zu beurteilen ist. Besonders hervorzuheben ist die signifikant erniedrigte Prozeßtemperatur, die zur Kristallisation der Pufferschicht notwendig ist. Während bei Lösung 1 eine Temperatur von 1100°C (1 h) benötigt wird, kann bei Lösung 2 die Glühung bei Temperaturen deutlich unterhalb von 1000°C erfolgen, z.B. 800 oder 900°C, jeweils für 2 Stunden gemäß Abbildung 4. In beiden Fallen wird eine Formiergasatmosphäre (Ar/5%H₂) benötigt. Die Formiergasatmosphäre wird dabei so gewählt, daß einerseits das Metallband nicht oxidiert wird, sich andererseits die Oxidschicht noch ausbilden kann.

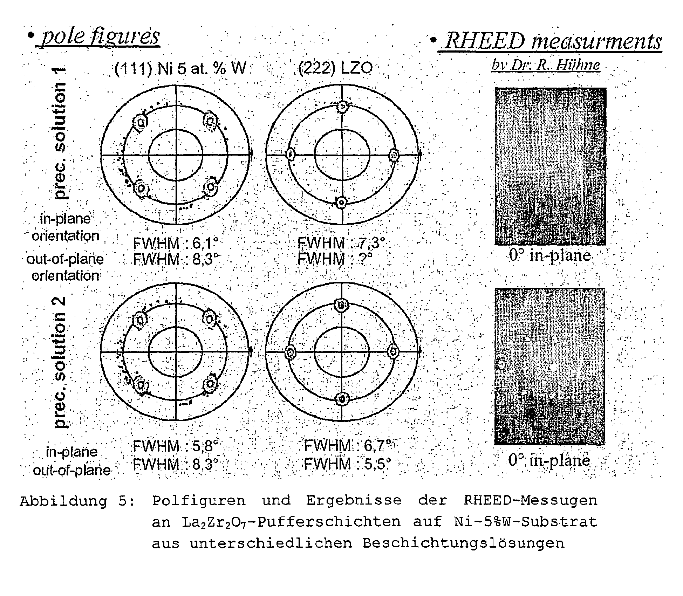

Während die Röntgenbeugungsdiagramme der Schichten bereits geringe Unterschiede zwischen den Lösungen zeigen, kann über RHEED Aufnahmen, welche die Textur des obersten Nanometer-Bereichs der Pufferschicht zeigen, ein deutlicher Unterschied festgestellt werden. Abbildung 5 zeigt Polfiguren von Metallsubstrat und Pufferschicht sowie RHEED Aufnahmen der unterschiedlichen Schichten.

Während wie erwartet die Polfiguren nur geringe Unterschiede aufweisen, zeigt die RHEED Aufnahme im Fall von Lösung 1 (Beschichtungslösung nach dem Stand der Technik) ausschließlich Beugungsringe. Beugungsringe stehen für eine regellose zufällige Anordnung der Kristallite im Raum - also keinerlei Textur im untersuchten äußeren Bereich der Pufferschicht. Im Gegensatz dazu zeigt die RHEED Aufnahme der Pufferschicht, welche mit Lösung 2 abgeschieden wurde, diskrete Reflexe gleichbedeutend mit einer starken Texturierung im untersuchten Bereich bis an die Oberfläche der Pufferschicht.

### Beispiel 2

Auf ein texturiertes Metallband (Ni - 5% W) wurde ebenfalls reproduzierbar über CSD-Verfahren Y₂O₃ aufgebracht. In Vergleichsversuchen wurden wie bereits in Beispiel 1 unterschiedliche Beschichtungslösungen verwendet. Lösung 1 entsprach dem Stand der Technik, während die zweite Lösung erfindungsgemäß ist.

In allen Versuchen war Y(III)-2,4-pentandionat (Yttrium(III)acetylacetonat, Y(CH₃COCHCOCH₃)₃ x H₂O: Alfa Aesar, 99,9%, Pulver) Ausgangsstoff. Die früheren Precursorlösungen wurden entsprechend dem Stand der Technik durch Verwendung von 2-Methoxyethanol (CH₃OCH₂CH₂OH: Merck, zur Analyse, ACS, 99,3%, Schmelzpunkt: -85°C, Siedepunkt: 124-125°C, Flammpunkt: 46°C) oder Acetylaceton (2,4-Pentandion, CH₃COCH₂COCH₃: Merck, ≥99,5%, Schmelzpunkt: -23°C, Siedepunkt: 140°C, Flammpunkt: 34°C), Methanol (CH₃OH: Merck, zur Analyse, ACS, ISO, ≥99,8%, Schmelzpunkt: -98°C, Siedepunkt: 64,5°C, Flammpunkt: 11°C) und Isobutylamin (1-Amino-2-methylpropan, (CH₃)₂CHCH₂NH₂: Merck, zur Synthese, >98%, Schmelzpunkt: -85°C, Siedetemperatur: 68°C, Flammpunkt: -10°C) (5 - 20% Isobutylamin in Acetylaceton) als Lösungsmittel hergestellt. Diese Lösungsmittel wurden bei der Herstellung der Precursorlösungen entsprechend der Erfindung zu 45 bis 100%, bevorzugt 90 - 100%, durch Propionsäure (Propionsäure, CH₃CH₂COOH: Merck, ≥99%, Schmelzpunkt: -21°C, Siedepunkt: 141°C, Flammpunkt: 50°C) ersetzt.

Die Konzentration der untersuchten Lösungen wurde auf 0,125 M bezogen auf Y₂O₃ eingestellt.

Die Beschichtung erfolgte an Substratstücken mit den Abmessungen 10 x 10 x 0,08 mm³ mittels einer Tauchapparatur. Die Proben wurden mit einer Geschwindigkeit von 0,1 cm/s mit einem Winkel von 90° zur Lösungsoberfläche aus der Beschichtungslösung gezogen.

Nach der Trocknung an Luft bei 60°C innerhalb von 1h und anschließend bei 90°C innerhalb von 0,5h wurden die Proben bei 1000°C 1h in Ar/5%H₂ geglüht.

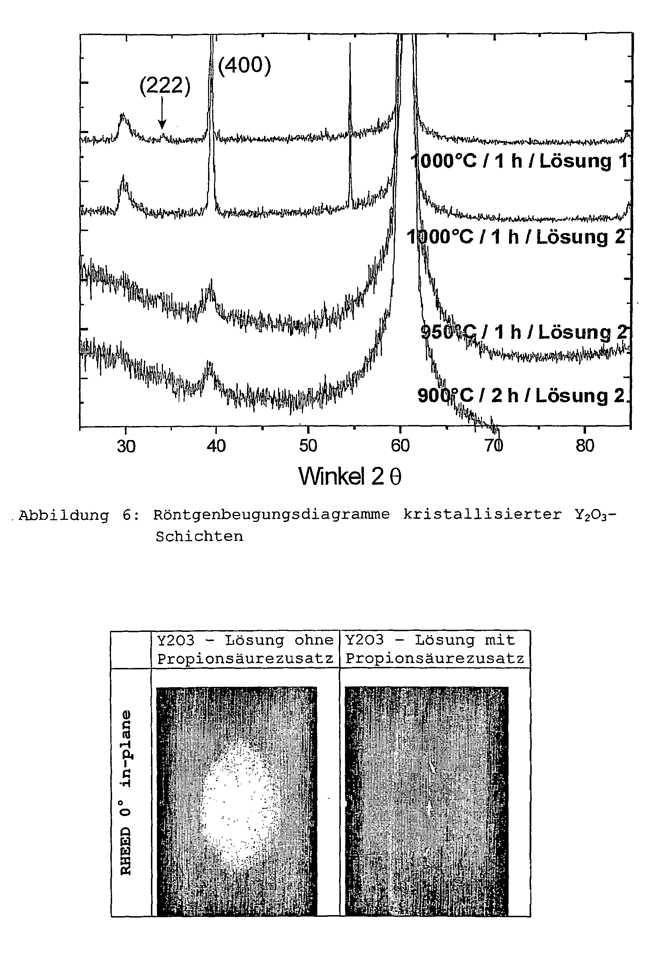

Die Röntgendiffraktogramme der Schichten, die unter Verwendung von Propionsäure hergestellt wurden, zeigen im Röntgendiffraktogramm deutlich höhere Intensitäten der (h00)-Reflexe als die Y₂O₃-Schichten, die nach dem Stand der Technik erhalten wurden. Die höchste Intensität des Y₂O₃ (400)-Reflexes wurde an einer Pufferschicht gemessen, die mit einem Propionsäuregehalt von 50% in der Lösungsmittelzusammensetzung hergestellt wurde. Die gute Textur der Probe kann zusätzlich durch das Fehlen des Y₂O₃ (222)-Reflexes belegt werden (Abbildung 6).

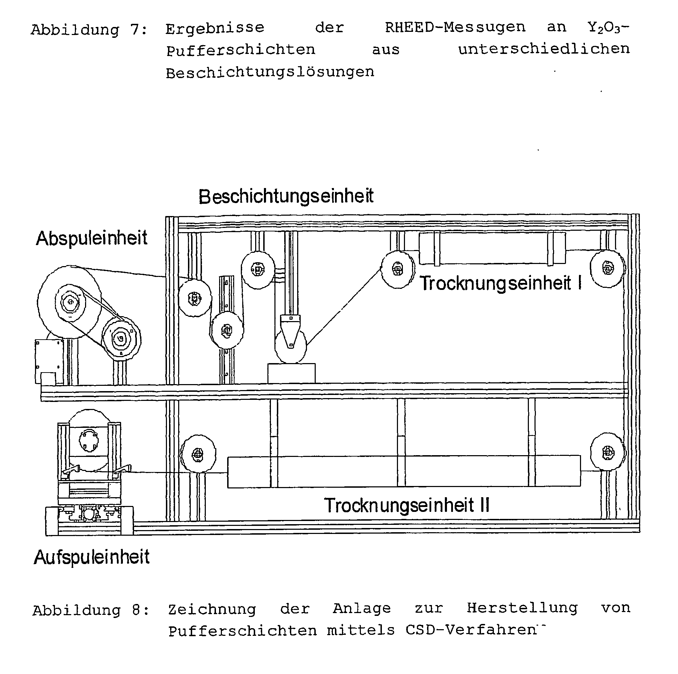

Die Polfiguren an ohne Propionsäurezusatz hergestellten Schichten zeigen in-plane Textur. Untersuchungen mittels RHEED ergaben, daß diese Schichten nicht bis zur Oberfläche in gleicher Qualität texturiert sind, sondern daß an der Oberfläche noch amorphe bzw. polykristalline Anteile vorliegen. Im Gegensatz dazu ist bei der Schicht, die entsprechend der Erfindung hergestellt wurde, bis an die Oberfläche in plane-Textur vorhanden (Abbildung 7).

### Beispiel 3

Auf ein texturiertes Metallband (Ni - 5 % W) wurde in reproduzierbaren Versuchen erfindungsgemäß La₂Zr₂O₇ (LZO) als Pufferschicht aufgebracht.

Basis der Beschichtungslösung sind Lanthan(III)- und Zirkonium(IV)-(2,4)pentandionat (Acetylacetonat) (Lanthan(III)-(2,4)pentan-dionat, La[CH₃COCHCOCH₃]₃ ·x H₂O: Alfa Aesar, 99,9% (REO), Pulver, Schmelzpunkt: 143°C; Zirkonium(IV)-(2,4)pentandionat, Zr [CH₃COCHCOCH₃]₄: Strem Chemicals, ≥98%, kristallin). Die Lösung wurde gemäß der Pufferstöchiometrie auf eine Konzentration von 0,1 M bezogen auf La₂Zr₂O₇ eingestellt.

Zur genauen Einstellung der Metallgehalte wurden die Ausgangsstoffe mittels ICP-OES (Inductively coupled plasma optical emission) charakterisiert. Als Lösungsmittel für die Lösung wurde Propionsäure (Propionsäure, CH₃CH₂COOH: Merck, ≥99%, Schmelzpunkt: -21°C, Siedepunkt: 141°C, Flammpunkt: 50°C) verwendet.

Die Beschichtung erfolgte an Substratbändern mit einem Querschnitt von 5 x 0,1 mm² und einer Länge von 50 m in einer kontinuierlichen Beschichtungsapparatur.

Diese Apparatur besteht aus einer Abspul-, einer Beschichtungs-, einer Trocknungs- und einer Aufwickeleinheit. Eine schematische Zeichnung zeigt Abbildung 8. Das Band wird unter einem Zug von 10N mit einer Geschwindigkeit von 5cm/min durch die Anlage gezogen. Die Zugkraft wird dabei so gewählt, daß sie geringer ist als die Streckgrenze des verwendeten Metallbandes. Die Beschichtung erfolgt mit einem Auszugswinkel von 70° bezogen auf die Lösungsoberfläche. Der Auszugswinkel kann in einem Bereich von 20 - 90° variiert werden, wobei ein geringerer Winkel eine größere Schichtdicke bedeutet. Gleiche Schichtdicken können z.B. mit der Kombination 70° und 5cm/min sowie 90° und 5,8cm/min erreicht werden. Die Trocknung erfolgt in zwei Schritten. Die Vortrocknung erfolgt unterhalb der Siedetemperatur des Lösungsmittels (Methanol; 65°C) bei Temperaturen von 60°C auf einer Strecke von 50cm die Endtrocknung auf einer Strecke von 100cm bei einer Temperatur von 90°C. Das Band wird nach der Trocknung auf ein Keramikrohr (Korund) mit dem Durchmesser von 20 cm und einer Länge von 100 cm in Form einer Spirale (Solenoid) aufgewickelt.

Das Band wird mit dem Trägerrohr in einen Glühofen überführt und bei einer Temperatur von 900°C innerhalb von 2h kristallisiert.

Untersuchungen mittels RHEED und Röntgendiffraktometrie an ausgewählten Kurzproben ergaben Messergebnisse, die denen der Messungen an den erfindungsgemäß hergestellten Proben aus Beispiel 1 entsprechen.

### Beispiel 4

In diesem Beispiel wurde ein Puffersystem bestehend aus zwei Schichten La₂Zr₂O₇ (LZO) und einer Schicht Gadolinium-dotiertes Ceroxid (CGO) aufgebracht.

Die ersten beiden Schichten wurden gemäß Bespiel 3 nacheinander unter Durchlaufen aller beschriebener Prozeßschritte aufgebracht. Auch nach dieser Mehrfachbeschichtung zeigten Untersuchungen mittels RHEED und Röntgendiffraktometrie an ausgewählten Kurzproben Messergebnisse, die denen der Messungen an den erfindungsgemäß hergestellten Proben aus Beispiel 1 entsprechen.

Die Beschichtungslösung für das Gadolinium-dotierte Ceroxid basiert auf einer Mischung aus Cer(III)acetylacetonat in 2-Methoxyethanol (Cer(IV)methoxyethoxid, Ce (CH₃OCH₂CH₂O)₄·xH₂O; Alfa Aesar; 99,9% und 2 Methoxyenthanol, CH₃OCH₂CH₂OH; Sigma-Aldrich Chemie; 99,8% wasserfrei, Siedepunkt 124°C) und Gd(III)acetylacetonat in Propionsäure (Gd(III)acetylacetonat, Gd(CH₃CO₂)₃·xH₂O; Sigma-Aldrich Chemie, 99.9% und Propionsäure, CH₃CH₂COOH: Merck, ≥99%, Schmelzpunkt: -21°C, Siedepunkt: 141°C, Flammpunkt: 50°C). Das Verhältnis von Gadolinium zu Cer beträgt 0,01/1 bis 0,1/1. Die Lösungskonzentration wurde auf 0,2M eingestellt. Die Beschichtungslösung wurde analog zu Beispiel 3 aufgebracht. Die Kristallisation erfolgte bei Temperaturen von 1000°C innerhalb einer Stunde.

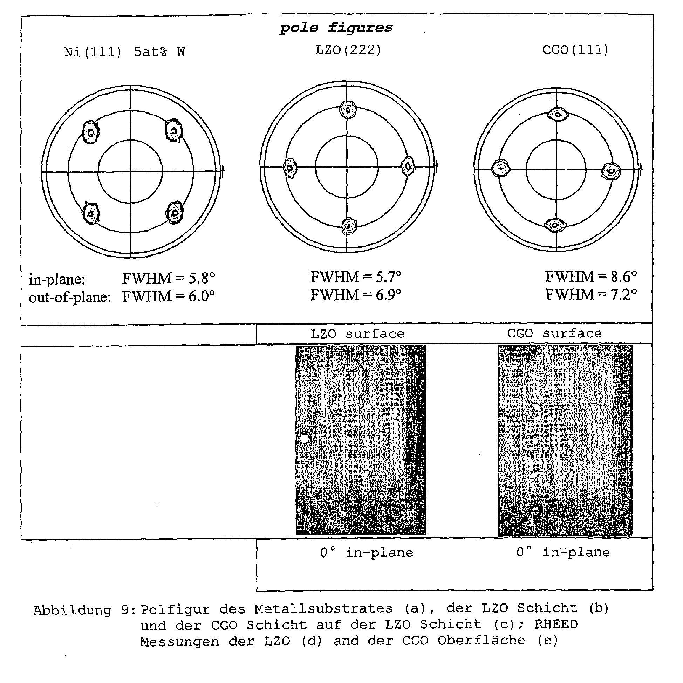

Die Polfiguren und die RHEED Messungen (Abbildung 9) zeigen eine sehr gute Kristallorientierung und einen hohen Texturgrad der Oberfläche.

Anstelle einer Gadolinium-dotierten Ceroxidschicht kann alternativ eine reine Ceroxidschicht aufgebracht werden. Die Beschichtungslösung besteht hier aus Ce(III)-acetat gelöst in Propionsäure, 2-Propanol und Acetylaceton (Ce(III)-acetat, Ce(CH₃COO)₃·xH₂O; Sigma-Aldrich Chemie, 99,9% und Propionsäure, CH₃CH₂COOH: Merck, ≥99%, Schmelzpunkt: -21°C, Siedepunkt: 141°C, Flammpunkt: 50°C und 2-Propanol (Isopropanol), (CH₃)₂CHOH; Sigma-Aldrich Chemie, 99,5%, Siedepunklt 82°C und Acetylaceton, CH₃COCH₂COCH₃; Sigma-Aldrich Chemie, >99%, Siedepunkt 140°C. Die Lösungsmittel hatten das Verhältnis 5:2:1, wobei in einem weiten Bereich mit Anteil Propionsäure > 50% variiert werden kann. Die Lösungskonzentration wurde auf 0,25M eingestellt. Die Beschichtungslösung wurde analog zu Beispiel 3 aufgebracht. Die Kristallisation erfolgte bei Temperaturen von 950°C innerhalb einer Stunde. Polfiguren und RHEED Messungen zeigten Ergebnisse entsprechend denen des Gadolinium-dotierten Ceroxides

## Patentansprüche

1. Verfahren zur Herstellung von bandförmigen HTSL, aus einem Metallsubstrat, mindestens einer Pufferschicht aus yttriumstabilisiertem Zirkonoxid oder Gadolinium-Zirkonat oder Yttriumoxid oder Lanthan-Aluminat oder Lanthan-Zirkonat oder Strontium-Titanat oder Nickeloxid oder Ceroxid oder Lanthan-Manganat oder Strontium-Ruthenat und einem auf der Pufferschicht befindlichen HTSL, mit den Schritten:
a) Herstellen einer Beschichtungslösung enthaltend ein polares Lösungsmittel mit mindestens einer freien Hydoxylgruppe,
b) Aufbringen der Beschichtungslösung auf das Metallsubstrat,
c) Trocknen,
d) Erzeugen der Pufferschicht durch Glühbehandlung, und
e) Aufbringen einer HTSL Schicht auf die Pufferschicht,
**dadurch gekennzeichnet, dass** als polares Lösungsmittel Propionsäure verwendet wird.

2. Verfahren nach Anspruch 1, **dadurch gekennzeichnet, dass** vor dem Verfahrensschritt (e) die Schritte (a) bis (d) mindestens einmal wiederholt werden.

3. Verfahren nach Anspruch 1 oder 2, **dadurch gekennzeichnet, dass** mindestens eine Beschichtungslösung Lanthan(III) - und Zirkonium(IV) - (2,4) pentandionat gelöst in Propionsäure enthält.

4. Verfahren nach Anspruch 3, **dadurch gekennzeichnet, dass** die Beschichtungslösung eine Konzentration im Bereich von 0,04M bis 0,5M bezogen auf La₂Zr₂O₇ hat.

5. Verfahren nach einem der Ansprüche 1 bis 4, **dadurch gekennzeichnet, dass** die Glühbehandlung der Beschichtung bei Temperaturen von 800° - 900° C erfolgt.

6. Verfahren nach einem der Ansprüche 1 bis 5, **dadurch**
**gekennzeichnet, dass** mindestens eine Beschichtung mittels einer Tauchapparatur erfolgt, und das Substrat mit einer Geschwindigkeit zwischen etwa 0,05 cm/s und 0,5cm/s aus dem Tauchbecken gezogen wird.

7. Verfahren nach einem der Ansprüche 1 bis 5, **dadurch gekennzeichnet, dass** mindestens eine Beschichtung mittels einer kontinuierlichen Beschichtungsapparatur unter einem Auszugswinkel zwischen etwa 20° - 90° bei einer Zuggeschwindigkeit zwischen etwa 0,05cm/s und 0,15 cm/s erfolgt.

8. Verfahren nach einem der Ansprüche 1 bis 5, **dadurch gekennzeichnet, dass** mindestens eine Beschichtungslösung aus Yttrium(III) - (2,4) pentandionat, gelöst in einem Gemisch aus Methoxyalkohol, und/oder Acetylaceton und/oder Methanol und/oder Isobutylamin sowie 24% -100% Propionsäure besteht.

9. Verfahren nach Anspruch 8, **dadurch gekennzeichnet, dass** die Beschichtung bei etwa 1000°C geglüht wird.

10. Verfahren nach einem der Ansprüche 1 bis 9, **dadurch gekennzeichnet, dass** bei Erzeugen mindestens einer Pufferschicht aus Ceroxid, Gd-dotiertes Ceroxid erzeugt wird.

11. Verfahren zur Herstellung von bandförmigen-HTSL, mit einem Metallsubstrat, zwei Pufferschichten aus La₂Zr₂O₇, einer Pufferschicht aus gadoliniumdotiertem Ceroxid und mindestens einer Schicht aus einem HTSL, mit den Schritten:
a) Herstellen einer ersten Beschichtungslösung, enthaltend Lanthan(III) - und Zirkonium(IV) - (2,4) pentandionat gelöst in Propionsäure,
b) Aufbringen der ersten Beschichtungslösung auf das Metallsubstrat,
c) Trocknen,
d) Erzeugen einer ersten La₂Zr₂O₇ Pufferschicht durch Glühbehandlung,
e) nochmaliges Aufbringen der ersten Beschichtungslösung,
f) Trocknen,
g) Erzeugen einer zweiten La₂Zr₂O₇ Pufferschicht durch Glühbehandlung,
h) Herstellen einer zweiten Beschichtungslösung, basierend auf einer Mischung aus Cer(III)acetylacetonat in 2-Methoxyethanol und Gd(III)acetylacetonat in Propionsäure,
i) Aufbringen der zweiten Beschichtungslösung auf die zweite La₂Zr₂O₇ Pufferschicht,
j) Trocknen,
k) Erzeugen einer dritten Pufferschicht aus Gadoliniumdotiertem Ceroxid durch Glühbehandlung,
l) Aufbringen einer HTSL - Schicht auf die im vorangegangen Schritt erzeugte Pufferschicht.

12. Verfahren nach Anspruch 11, **dadurch gekennzeichnet, dass** die Konzentration der zweiten Beschichtungslösung 0,1M bis 0,4M, bezogen auf den Gesamtmetallgehalt CeO₂/Gd₂O₃, beträgt.

13. Verfahren zur Herstellung von bandförmigen HTSL mit einem Metallsubstrat, zwei Pufferschichten aus La₂Zr₂O₇, einer Pufferschicht aus Ceroxid und mindestens einer Schicht aus einem HTSL, mit den Schritten:
a) Herstellen einer ersten Beschichtungslösung, enthaltend Lanthan(III) - und Zirkonium(IV) - (2,4) pentandionat, gelöst in Propionsäure,
b) Aufbringen der ersten Beschichtungslösung auf das Metallsubstrat,
c) Trocknen,
d) Erzeugen einer ersten La₂Zr₂O₇ Pufferschicht durch Glühbehandlung,
e) nochmaliges Aufbringen der ersten Beschichtungslösung,
f) Trocknen,
g) Erzeugen einer zweiten Pufferschicht La₂Zr₂O₇ durch Glühbehandlung,
h) Herstellen einer zweiten Beschichtungslösung, basierend auf einer Mischung aus Cer(III)acetat, gelöst in Propionsäure, 2-Propanol und Acetylaceton,
i) Aufbringen der zweiten Beschichtungslösung auf die zweite La₂Zr₂O₇ Pufferschicht,
j) Trocknen,
k) Erzeugen einer dritten Pufferschicht aus Ceroxid durch Glühbehandlung,
l) Aufbringen einer HTSL-Schicht auf die Pufferschicht.

14. Verfahren nach Anspruch 13, **dadurch gekennzeichnet, dass** das Lösungsmittelgemisch der zweiten Beschichtungslösung aus mindestens 50% Propionsäure besteht.

15. Verfahren nach Anspruch 14, **dadurch gekennzeichnet, dass** die Lösungsmittel Propionsäure, 2-Propanol und Acetylaceton der zweiten Beschichtungslösung im Verhältnis von etwa 5:2:1 stehen.

16. Verfahren nach einem der vorhergehenden Ansprüche, **dadurch gekennzeichnet, dass** das Metallsubstrat texturiert ist.

17. Verfahren nach einem der vorhergehenden Ansprüche, **dadurch gekennzeichnet, dass** das Metallsubstrat aus Reinnickel ist.

18. Verfahren nach einem der vorhergehenden Ansprüche, **dadurch gekennzeichnet, dass** die Trocknung der Beschichtungslösungen bei mindestens zwei verschiedenen Temperaturen erfolgt, wovon die Anfangstemperatur unterhalb der Siedetemperatur und die Endtemperatur oberhalb der Siedetemperatur der jeweiligen Lösungsmittel liegt.

19. Verfahren nach einem der vorhergehenden Ansprüche, **dadurch gekennzeichnet, dass** die Beschichtungslösung vor Aufbringen auf das Substrat erhitzt wird.

20. Verfahren nach einem der vorhergehenden Ansprüche, **dadurch gekennzeichnet, daß** der Beschichtungslösung Gelier- und/oder Benetzungsmittel zugesetzt wird.

## Claims

1. A method for producing strip-like high-temperature superconductors (HTSCs), made of a metal substrate, at least one buffer layer made of yttrium-stabilized zirconium oxide or gadolinium zirconate or yttrium oxide or lanthanum aluminate or lanthanum zirconate or strontium titanate or nickel oxide or cerium oxide or lanthanum manganate or strontium ruthenate and an HTSC disposed on the buffer layer, with the following steps:
a) production of a coating solution containing a polar solvent with at least one free hydroxyl group;
b) application of the coating solution to the metal substrate;
c) drying;
d) production of the buffer layer by annealing treatment,
e) application of an HTSC layer to the buffer layer;
and
**characterized in that** propionic acid is used as a polar solvent.

2. A method according to claim 1, **characterized in that** the steps (a) to (d) are repeated at least once before the method step (e).

3. A method according to claim 1 or 2, **characterized in that** at least one coating solution contains lanthanum (III)- and zirconium (IV)-(2,4) pentanedionate dissolved in propionic acid.

4. A method according to claim 3, **characterized in that** the coating solution has a concentration in the range of 0.04M to 0.5M relating to La₂Zr₂O₇.

5. A method according to one of the claims 1 to 4, **characterized in that** the annealing treatment of the coating occurs at temperatures of 800° to 900°.

6. A method according to one of the claims 1 to 5, **characterized in that** at least one coating occurs by means of a dipping apparatus, and the substrate is pulled out of the dipping basin with a speed of between approx. 0.05 cm/s and 0.5 cm/s.

7. A method according to one of the claims 1 to 5, **characterized in that** at least one coating occurs by means of a continuous coating apparatus under a draw-out angle of between 20° to 90° at a drawing speed of between 0.05 cm/s and 0.15 cm/s.

8. A method according to one of the claims 1 to 5, **characterized in that** at least one coating solution consists of yttrium(III)-(2,4) pentanedionate, dissolved in a mixture of methoxy alcohol, and/or acetylacetone and/or methanol and/or isobutylamine and 24% to 100% propionic acid.

9. A method according to claim 8, **characterized in that** the coating is annealed at approx. 1000°C.

10. A method according to one of the claims 1 to 9, **characterized in that** Gd-doped cerium oxide is produced upon producing at least one buffer layer made of cerium oxide.

11. A method for producing strip-like HTSCs, comprising a metal substrate, two buffer layers made of La₂Zr₂O₇, a buffer layer made of gadolinium-doped cerium oxide and at least one layer made of an HTSC, with the following steps:
a) production of a first coating solution, containing lanthanum(III)- and zirconium(IV)-(2,4) pentanedionate dissolved in propionic acid;
b) application of the first coating solution to the metal substrate;
c) drying;
d) production of a first La₂Zr₂O₇ buffer layer by annealing treatment;
e) renewed application of the first coating solution;
f) drying;
g) production of a second La₂Zr₂O₇ buffer layer by annealing treatment;
h) production of a second coating solution, based on a mixture of cerium (III) acetylacetonate in 2-methoxy ethanol and Gd (III) acetylacetonate in propionic acid;
i) application of the second coating solution to the second La₂Zr₂O₇ buffer layer;
j) drying;
k) production of a third buffer layer made of gadolinium-doped cerium oxide by annealing treatment;
l) application of an HTSC layer to the buffer layer produced in the preceding step.

12. A method according to claim 11, **characterized in that** the concentration of the second coating solution is 0.1 M to 0.4 M, relating to the total metal content of CeO₂/Gd₂O₃.

13. A method for producing a strip-like HTSCs, comprising a metal substrate, two buffer layers made of La₂Zr₂O₇, a buffer layer made of cerium oxide and at least one layer made of an HTSC, with the following steps:
a) production of a first coating solution, containing lanthanum(III)- and zirconium(IV)-(2,4) pentanedionate dissolved in propionic acid;
b) application of the first coating solution to the metal substrate;
c) drying;
d) production of a first La₂Zr₂O₇ buffer layer by annealing treatment;
e) renewed application of the first coating solution;
f) drying;
g) production of a second La₂Zr₂O₇ buffer layer by annealing treatment;
h) production of a second coating solution, based on a mixture of cerium (III) acetate, dissolved in propionic acid, 2-propanol and acetylacetone;
i) application of the second coating solution to the second La₂Zr₂O₇ buffer layer;
j) drying;
k) production of a third buffer layer made of cerium oxide by annealing treatment;
l) application of an HTSC layer to the buffer layer.

14. A method according to claim 13, **characterized in that** the solvent mixture of the second coating solution consists of at least 50% propionic acid.

15. A method according to claim 14, **characterized in that** the solvents of propionic acid, 2-propanol and acetylacetone of the second coating solution are provided at a ratio of approx. 5:2:1.

16. A method according to one of the preceding claims, **characterized in that** the metal substrate is textured.

17. A method according to one of the preceding claims, **characterized in that** the metal substrate is made of pure nickel.

18. A method according to one of the preceding claims, **characterized in that** the drying of the coating solutions occurs at at least two different temperatures, whereof the initial temperature lies beneath the boiling temperature and the final temperature lies above the boiling temperature of the respective solvent.

19. A method according to one of the preceding claims, **characterized in that** the coating solution is heated prior to the application of the substrate.

20. A method according to one of the preceding claims, **characterized in that** gelling agents and/or wetting agents are added to the coating solution.

## Revendications

1. Procédé pour la fabrication de supraconducteurs à haute température en forme de bandes à partir d'un substrat métallique, d'au moins une couche tampon en oxyde de zirconium stabilisé à l'yttrium ou en zirconate de gadolinium ou en oxyde d'yttrium ou en aluminate de lanthane ou en zirconate de lanthane ou en titanate de strontium ou en oxyde de nickel ou en oxyde de cérium ou en manganate de lanthane ou en ruthénate de strontium, et d'un supraconducteur à haute température appliqué sur la couche tampon, comprenant les étapes de :
a) fabrication d'une solution de revêtement contenant un solvant polaire avec au moins un groupement hydroxyle libre,
b) application de la solution de revêtement sur le substrat métallique,
c) séchage,
d) création de la couche tampon par traitement thermique, et
e) application d'une couche de supraconducteur à haute température sur la couche tampon,
**caractérisé en ce que** le solvant polaire utilisé est de l'acide propionique.

2. Procédé selon la revendication 1, **caractérisé en ce que** les étapes (a) à (d) sont répétées au moins une fois avant l'étape (e) du procédé.

3. Procédé selon la revendication 1 ou 2, **caractérisé en ce qu'**au moins une solution de revêtement contient du (2,4)-pentanedionate de lanthane (III) et de zirconium (IV) en solution dans l'acide propionique.

4. Procédé selon la revendication 3, **caractérisé en ce que** la solution de revêtement présente une concentration comprise entre 0,04 M et 0,5 M par rapport au La₂Zr₂O₇.

5. Procédé selon l'une des revendications 1 à 4, **caractérisé en ce que** le traitement thermique du revêtement s'effectue à une température de 800°-900°C.

6. Procédé selon l'une des revendications 1 à 5, **caractérisé en ce qu'**au moins un revêtement est réalisé au moyen d'un appareillage d'immersion, et le substrat est retiré du bac d'immersion à une vitesse comprise entre 0,05 cm/s et 0,5 cm/s.

7. Procédé selon l'une des revendications 1 à 5, **caractérisé en ce qu'**au moins un revêtement est réalisé au moyen d'un appareillage de revêtement en continu sous un angle d'extraction compris entre 20° et 90°, à une vitesse de traction comprise entre 0,05 cm/s et 0,15 cm/s.

8. Procédé selon l'une des revendications 1 à 5, **caractérisé en ce qu'**au moins une solution de revêtement se compose de (2,4)-pentanedionate d'yttrium (III) en solution dans un mélange d'alcool méthoxylique et/ou d'acétylacétone et/ou de méthanol et/ou d'isobutylamine et de 24 % à 100 % d'acide propionique.

9. Procédé selon la revendication 8, **caractérisé en ce que** le revêtement est recuit à environ 1000°C.

10. Procédé selon l'une des revendications 1 à 9, **caractérisé en ce que** lors de la création d'au moins une couche tampon en oxyde de cérium, de l'oxyde de cérium dopé au gadolinium est produit.

11. Procédé pour la fabrication de supraconducteurs à haute température en forme de bandes avec un substrat métallique, deux couches tampon en La₂Zr₂O₇, une couche tampon en oxyde de cérium dopé au gadolinium et au moins une couche d'un supraconducteur à haute température, comprenant les étapes de :
a) fabrication d'une première solution de revêtement contenant du (2,4)-pentanedionate de lanthane (III) et de zirconium (IV) en solution dans l'acide propionique,
b) application de la première solution de revêtement sur le substrat métallique,
c) séchage,
d) création d'une première couche tampon en La₂Zr₂O₇ par traitement thermique,
e) nouvelle application de la première solution de revêtement,
f) séchage,
g) création d'une deuxième couche tampon en La₂Zr₂O₇ par traitement thermique,
h) fabrication d'une deuxième solution de revêtement à base d'un mélange d'acétylacétonate de cérium (III) dans du 2-méthoxyéthanol et d'acétylacétonate de gadolinium (III) dans de l'acide propionique,
i) application de la deuxième solution de revêtement sur la deuxième couche tampon en La₂Zr₂O₇,
j) séchage,
k) création d'une troisième couche tampon en oxyde de cérium dopé au gadolinium par traitement thermique,
l) application d'une couche de supraconducteur à haute température sur la couche tampon créée dans l'étape précédente.

12. Procédé selon la revendication 11, **caractérisé en ce que** la concentration de la deuxième solution de revêtement est de 0,1 % à 0,4 M par rapport à la teneur totale en métal de CeO₂/Gd₂O₃.

13. Procédé pour la fabrication de supraconducteurs à haute température en forme de bandes avec un substrat métallique, deux couches tampon en La₂Zr₂O₇, une couche tampon d'oxyde de cérium et au moins une couche d'un supraconducteur à haute température, comprenant les étapes de :
a) fabrication d'une première solution de revêtement, contenant du (2,4)-pentanedionate de lanthane (III) et de zirconium (IV) en solution dans de l'acide propionique,
b) application de la première solution de revêtement sur le substrat métallique,
c) séchage,
d) création d'une première couche tampon en La₂Zr₂O₇ par traitement thermique,
e) nouvelle application de la première solution de revêtement,
f) séchage,
g) création d'une deuxième couche tampon en La₂Zr₂O₇ par traitement thermique,
h) fabrication d'une deuxième solution de revêtement à base d'un mélange d'acétate de cérium (III) en solution dans l'acide propionique, le 2-propanol et l'acétylacétone,
i) application de la deuxième solution de revêtement sur la deuxième couche tampon en La₂Zr₂O₇,
j) séchage,
k) création d'une troisième couche tampon en oxyde de cérium par traitement thermique,
l) application d'une couche de supraconducteur à haute température sur la couche tampon.

14. Procédé selon la revendication 13, **caractérisé en ce que** le mélange de solvants de la deuxième solution de revêtement se compose à au moins 50 % d'acide propionique.

15. Procédé selon la revendication 14, **caractérisé en ce que** les proportions des solvants, acide propionique, 2-propanol et acétylacétone, de la deuxième solution de revêtement sont d'environ 5:2:1.

16. Procédé selon l'une des revendications précédentes, **caractérisé en ce que** le substrat métallique est texturé.

17. Procédé selon l'une des revendications précédentes, **caractérisé en ce que** le substrat métallique est en nickel pur.

18. Procédé selon l'une des revendications précédentes, **caractérisé en ce que** le séchage des solutions de revêtement s'effectue à au moins deux températures différentes, la température initiale étant inférieure à la température d'ébullition et la température finale supérieure à la température d'ébullition de chaque solvant.

19. Procédé selon l'une des revendications précédentes, **caractérisé en ce que** la solution de revêtement est chauffée avant l'application sur le substrat.

20. Procédé selon l'une des revendications précédentes, **caractérisé en ce que** la solution de revêtement est additionnée d'agents gélifiants et/ou mouillants.
